# EUROPÄISCHE PATENTSCHRIFT

(11) **EP 1 397 032 B1**
(45) Veröffentlichungstag und Bekanntmachung des Hinweises auf die Patenterteilung: **25.03.2009**
(21) Anmeldenummer: 03018153.1
(22) Anmeldetag: 08.08.2003
(51) Int. Cl.: H05K 7/14

(54) **Hilfsvorrichtung**
Assisting device
Dispositif d' assistance

(30) Priorität: 04.09.2002 DE 10240892
(43) Veröffentlichungstag der Anmeldung: 10.03.2004
(73) Patentinhaber: Fujitsu Siemens Computers GmbH, 80807 München (DE)
(72) Erfinder: Knoop, Franz Josef, 33142 Büren-Steinhausen (DE); Scharnetzke, Rainer, 33175 Bad-Lippspringe (DE)
(74) Vertreter: Epping - Hermann - Fischer

(56) Entgegenhaltungen:
- EP-A- 0 687 036
- DE-A- 3 602 446
- US-A- 5 657 204
- US-A- 6 094 358

## Beschreibung

Die Erfindung betrifft eine Hilfsvorrichtung zum Entnehmen einer Steckkarte aus einem Steckkörper, wie z. B. einem Slot auf dem Motherboard eines Computers.

Beim Eindrücken oder Ausziehen von PCI-Karten in bzw. aus dem Slot eines Computers müssen hohe Kräfte ausgeübt werden, da die Steckerkräfte der Steckkontakte im Stecker überbrückt werden müssen. Das Eindrücken dieser Steckkarten ist einfach, da durch die Direktsteckung auch die Steckkraft über den Kartenrücken erfolgen kann. Das Herausziehen dieser Steckkarten hingegen ist sehr schwierig, weil kein Griff oder dergleichen vorhanden ist, um die Karte zu fassen. Beim Ziehen der Steckkarten während des Betriebs des Computers (hot plug) muß gleichzeitig verhindert werden, daß die Karte eine benachbarte Karte und weitere Kontakte berührt. Die Karte muß somit exakt geführt ausgezogen werden, was bei der Überwindung der hohen Steckerkräfte oft kaum möglich ist.

Als Hilfsvorrichtung zur Entmahme von Steckkarten ist bereits bekannt, direkt an der Steckkarte einen Griff vorzusehen, so daß die Steckkarte an dem Griff nach oben herausgezogen werden kann. Ebenfalls ist es bekannt, in einer Trennwand zwischen zwei Steckkarten einen Griff an der Oberseite der Trennwand vorzusehen, wobei die Trennwand vor und hinter dem Steckkörper die Steckkarte untergreift, so daß durch Ziehen der Trennwand auch die Karte mit herausgezogen wird.

Der Nachteil dieser Ziehhilfen besteht darin, daß der Griff über den Kartenrücken übersteht und dadurch mehr Einbauvolumen und eine größere Bauhöhe in Anspruch genommen werden muß. Ein weiterer Nachteil des Griffs ist, daß die Karte nicht exakt geführt herausgezogen wird und nach Überwindung der Stekkerkräfte der Ausziehvorgang unter Umständen relativ ruckartig erfolgt und es dadurch zu Kurzschlüssen mit benachbarten Steckkarten beim Ausziehen während des Betriebs kommen kann.

In der Druckschrift DE 36 02 446 A1 wird eine Anordnung zum Eindrücken, Herausziehen und Verriegeln von elektrische Baugruppe, also zum Beispiel Steckkarten, beschrieben. Es ist ein Kulissenschieber vorgesehen, der mit dem Stecksockel verbunden ist. In entsprechende Aussparungen des Kulissenschiebers wird die elektrische Baugruppe mit an der Baugruppe vorgesehenen Haken oder Bolzen eingehängt. Bei Betätigung des Schiebers wird die Steckkarte in den Stecksockel hinein oder aus dem Stecksockel heraus bewegt. Eine ähnliche Anordnung, bei der aus einer Steckkarte herausragende Stifte mit Aussparungen an einem Schieber zusammenwirken, ist ebenfalls in der Druckschrift US 6,094,358 offenbart. Die Aussparungen sind als schräg verlaufende Schlitze ausgeführt, so daß bei Bewegung des Schiebers die Steckkarte in einer Richtung senkrecht zur Bewegungsrichtung des Schiebers in den Stecksockel hinein oder hinauszubewegt wird.

Beide beschriebenen Anordnungen haben den Vorteil, dass die hohen Steckkräfte durch mechanische Untersetztung bequem aufgebracht werden können. Von Nachteil ist, daß sie nur für speziell ausgelegte Steckkarten, die einen in die Aussparungen des Schiebers eingreifenden Stift, Bolzen oder Haken aufweisen, zusammenwirken können. Weiterhin ist ein Nachrüsten bestehender marktüblicher Stecksysteme ausgeschlossen.

Der Erfindung liegt daher die Aufgabe zugrunde, eine diesbezüglich verbesserte Hilfsvorrichtung aufzuzeigen.

Die Aufgabe wird erfindungsgemäß dadurch gelöst, daß am Steckkörper ein Kulissenschieber angeordnet ist, der einen um den Steckkörper angeordneten Unterkörper und einen Oberkörper aufweist, der durch die Betätigung des Kulissenschiebers nach oben bewegt wird und der geeignet ist, auf die Unterseite der Steckkarte einzuwirken, so daß die Steckkarte aus dem Steckkörper bewegbar ist.

Der Kulissenschieber setzt hierzu an der Unterseite der Karte im Bereich vor und hinter dem Steckkörper an, so daß die Karte gleichmäßig über den Kulissenschieber aus dem Steckkörper gedrückt wird. Durch den Kulissenschieber erfolgt gleichzeitig eine starke Untersetzung, so daß die Karte mit nur geringem Kraftaufwand aus dem Steckkörper gedrückt werden kann. Ist die Karte aus dem Steckkörper gedrückt, muß sie nur noch von Hand entnommen werden, ohne irgendwelche Steckkräfte überwinden zu müssen.

Ein weiterer Vorteil dieser Lösung liegt daran, daß kein händischer Eingriff im System mehr notwendig ist, bevor die Steckkarte elektrisch getrennt ist. Hierdurch können auch Störungen vermieden werden, die im nachhinein oft schwer nachvollziehbar sind.

Vorteilhaft an dieser Lösiung ist, daß die Hilfsvorrichtung in Form eines Kulissenschiebers in der gleichen Bauform für low profile Steckkarten wie auch für Standard-PCI-Steckkarten verwendbar ist.

Eine bevorzugte Ausführungsform der Erfindung sieht vor, daß die Hilfsvorrichtung in einem Computer mit Slotfeld angeordnet ist und der Kulissenschieber ein Betätigungsmittel aufweist, das durch das Slotfeld hindurchgeführt und von außen durch Ziehen oder Drücken bedienbar ist.

Gemäß einer alternativen Ausführungsform kann der Kulissenschieber auch über einen Hebel betätigt werden, der seitlich der Steckkarten angeordnet ist bzw. bei Vorliegen einen Isoliertrennwand zwischen den Steckkarten an der isolierten Wand angeordnet ist.

Weitere Vorteile der Erfindung sowie konstruktive Ausgestaltungen sind in den Unteransprüchen sowie in der nachfolgenden Figurenbeschreibung offenbart.

Anhand dreier in den Zeichnungen dargestellten Ausführungsbeispielen wird die Erfindung näher erläutert. In den Zeichnungen zeigen:
Figur 1 eine Schrägansicht zweier im Steckkörper eingesteckter Steckkarten mit erfindungsgemäßen Hilfsvorrichtungen,
Figur 2 eine Explosionsdarstellung der Hilfsvorrichtung,
Figur 3 zwei Steckkarten in Schrägansicht mit einer alternativen Ausführungsform der Hilfsvorrichtung,
Figur 4 zwei Steckkarten in Schrägansicht mit einer dritten Ausführungsform der Hilfsvorrichtung und
Figur 5 die Darstellung gemäß Figur 4 ohne Steckkarten, Slotfeld und Motherboard.

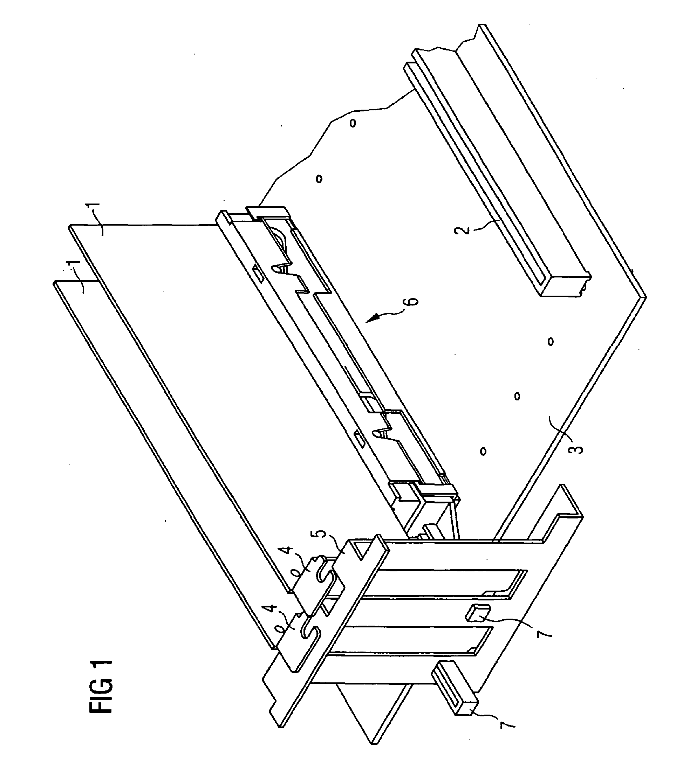

Figur 1 zeigt in Schrägansicht zwei Steckkarten 1, die jeweils im Steckkörper 2 in Form von PCI-Slots auf einem Motherboard 3 eingesteckt sind. Die Steckkarten sind stirnseitig mit üblichen Befestigungswinkeln 4 versehen. Damit können die Steckkarten durch Schrauben oder sonstige Befestigungsmechanismen an einem nur teilweise dargestellten Slotfeld 5 festgelegt werden.

Um die Steckkarten 1 leichter entnehmen zu können, ist pro Steckkörper ein Kulissenschieber 6 ausgebildet, über welchen die Steckkarte komfortabel aus dem Steckkörper 2 gedrückt werden kann, so daß sie lediglich nur von Hand entnommen werden muß.

Der Kulissenschieber 6 weist in dem in Figur 1 dargestellten Ausführungsbeispiel ein Betätigungsmittel 7 auf, welches durch eine Öffnung im Slotfeld 5 hindurchgeführt ist und somit von außen betätigt werden kann. In Figur 1 ist die linke Steckkarte eingesteckt, so daß das Betätigungsmittel 7 über die Außenseite des Slotfeldes 5 vorsteht. Durch Drücken auf das Betätigungsmittel 7, wie bei der rechten in Figur 1 dargestellten Steckkarte, wird diese durch den Kulissenschieber 6 aus dem Steckkörper 2 gedrückt, so daß kein elektrischer Kontakt zwischen der Steckkarte und dem Körper 2 mehr besteht.

Die Steckkarte 1 kann dann lediglich manuell ohne Überwindung irgendwelcher Steckkräfte entnommen werden.

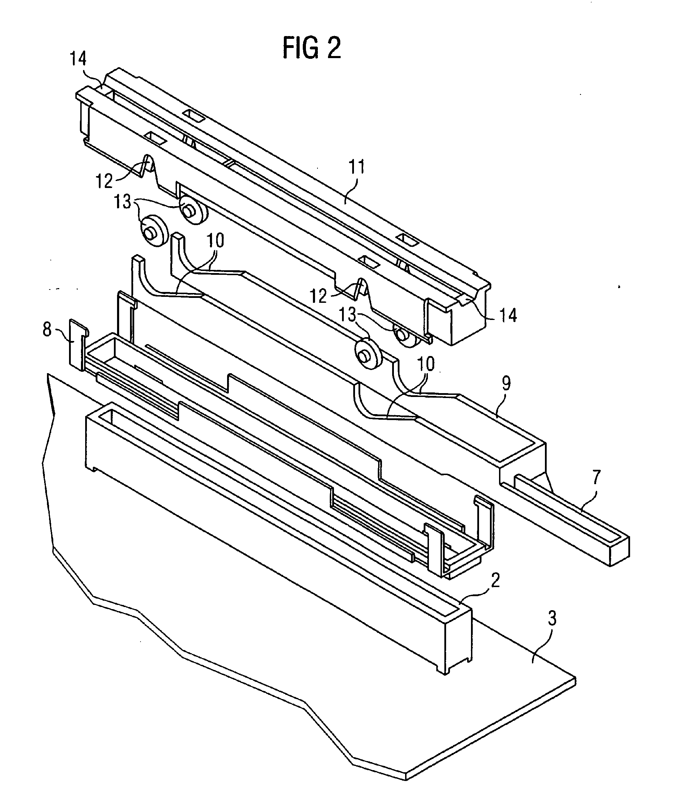

Figur 2 zeigt den Kulissenschieber 6 in einer Explosionsdarstellung. Der Kulissenschieber 6 weist einen rahmenartigen Unterkörper 8 auf, welcher über den Steckkörper 2 von oben geschoben werden kann. In dem Unterkörper 8 ist eine im wesentlichen U-förmig Kulissenmimik 9 angelegt, an deren Stirnseite das Betätigungsmittel 7 angeordnet ist. Die Kulissenmimik 9 weist zwei seitliche Flansche auf, die im eingebauten Zustand seitlich des Steckkörpers 2 angeordnet sind und in welchen jeweils die Kulissen in Form von vier schiefen Ebenen 10 ausgebildet sind.

Über den Unterkörper 8 sowie die Kulissenmimik 9 wird ein Oberkörper 11 gesteckt, welcher an der Unterseite Achsenaufnahmen 12 für Rollen 13 aufweist, die im zusammengebauten Zustand jeweils auf der Kulisse in Form der schiefen Ebene 10 abrollen.

Der Oberkörper 11 hat die weitere Funktion, daß er stirnseitig jeweils über zwei Stützflächen 14 die Karte vor und hinter dem Steckkörper 2 untergreift und somit durch die Bewegung der Kulissenmimik 9 die Steckkarte 1 über die Stützflächen 14 nach oben drückt.

Bei dem in Figur 2 dargestellten Ausführungsbeispiel wird auf das Betätigungsmittel 7 gedrückt, wodurch die Rollen 13 die schiefe Ebene 10 hinaufrollen und so über die Achsenaufnahmen 12 den Oberkörper 11 nach oben drücken.

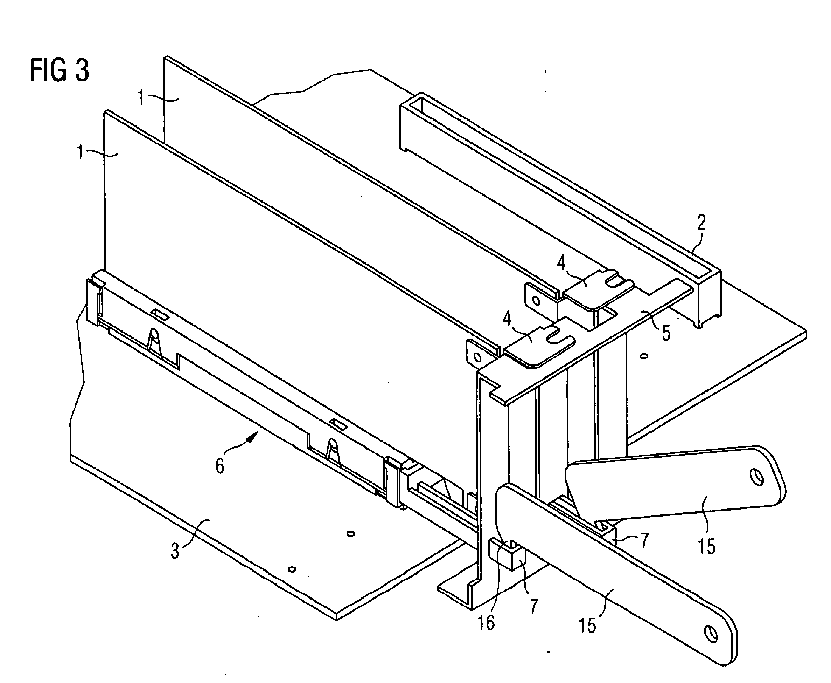

Figur 3 zeigt eine alternative Ausführungsform der Erfindung, wobei hier bei der Kulissenmimik 9 die schiefe Ebene 10 in die andere Richtung geneigt ist, so daß der Oberkörper 11 des Kulissenschiebers 6 durch Ziehen am Betätigungsmittel 7 nach oben bewegt wird.

In Figur 3 ist die linke Karte komplett eingesteckt und die rechte Karte durch Herausziehen der Kulissenmimik über das Betätigungsmittel 7 bereits ausgeworfen.

Das Betätigungsmittel 7 weist gemäß diesem Ausführungsbeispiel eine wannenartige Aussparung an der Oberseite auf, so daß über ein Hilfsmittel 5 mit einem hakenartigen Vorsprung 16 in die wannenartige Aussparung an der Oberseite des Betätigungsmittels 7 eingehakt und das Betätigungsmittel 7 und somit die Kulissenmimik 9 herausgezogen werden kann.

Diese Ausführungsform hat den Vorteil, daß nicht unbeabsichtigterweise eine Steckkarte 1 ausgeworfen wird, da ein zusätzliches Hilfsmittel 15 benötigt wird, wenn das Betätigungsmittel 7 herausgezogen werden soll.

Die Gefahr des unbeabsichtigten Auswerfens einer Steckkarte 7 ist zwar relativ gering, da diese am Slotfeld 5 über Schrauben oder sonstige Lösungen befestigt sind.

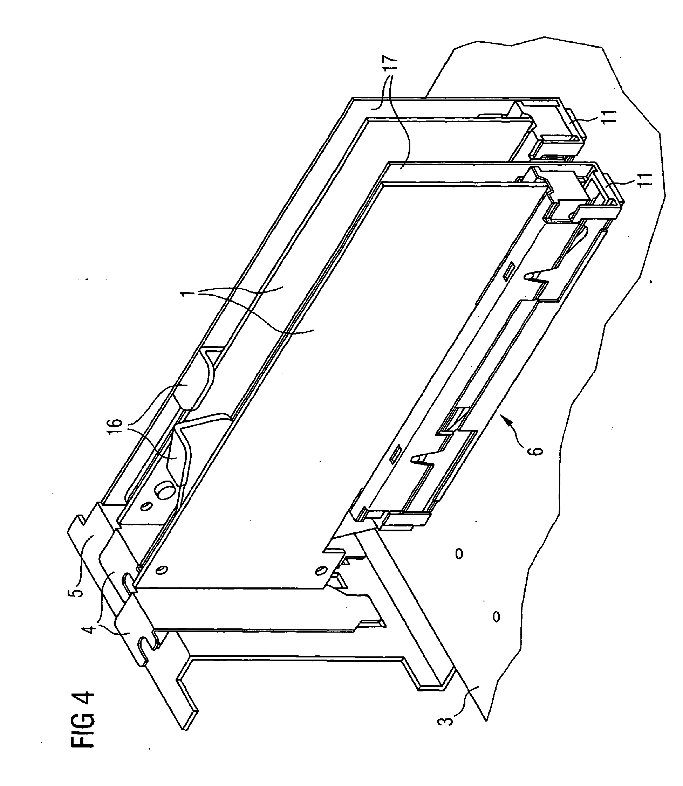

Figur 4 zeigt eine weitere Ausführungsform der Erfindung, wobei hier das Betätigungsmittel 7 über die Kulissenmimik 9 in Form eines Hebels 16 ausgebildet ist.

Der Hebel 16 ist von der Oberseite der Karte manuell ergreifbar und kann durch eine Bewegung Richtung Slotfeld 5, wie bei der linken in Figur 4 dargestellten Steckkarte 1 betätigt werden.

Bei dem in Figur 4 dargestellten Ausführungsbeispiel ist von dem Unterkörper 11 eine Seitenwandung als isolierende Trennwand 17 bis zur Höhe der aufzunehmenden Steckkarten 1 nach oben gezogen, so da zusätzlich beim Stecken oder Ziehen der Steckkarten 1 die Gefahr von Kurzschlüssen vermieden wird.

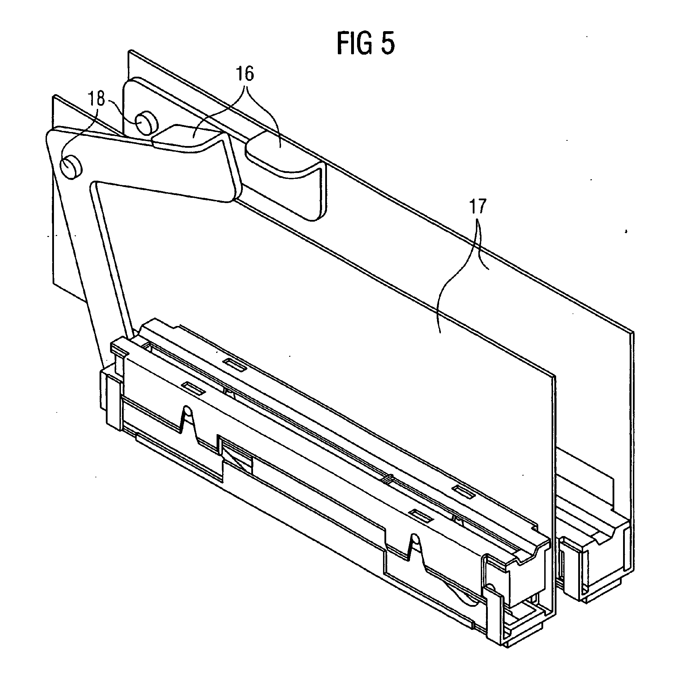

Figur 5 zeigt die Darstellung gemäß Figur 4 ohne Slotfeld 5, Motherboard 3 und Steckkarten 1.

Der Hebel 16 wird gemäß diesem Ausführungsbeispiel um eine Achse 18 geschwenkt, welche in der isolierenden Seitenwand 17 festgelegt ist.

Diese Lösung hat den Vorteil, daß das Slotfeld 5 nicht auf den Kulissenschieber 6 abgestimmt werden muß, da kein Durchbruch für das Betätigungsmittel 7 erforderlich ist.

### Bezugszeichenliste

- 1: Steckkarten
- 2: Steckkörper
- 3: Motherboard
- 4: Befestigungswinkel
- 5: Slotfeld
- 6: Kulissenschieber
- 7: Betätigungsmittel
- 8: rahmenartiger Unterkörper
- 9: Kulissenmimik
- 10: schiefe Ebene
- 11: Oberkörper
- 12: Achsaufnahmen
- 13: Rollen
- 14: Stützflächen
- 15: Hilfsmittel
- 16: Hebel
- 17: isolierende Trennwand

## Patentansprüche

1. Hilfsvorrichtung zur Entnahme einer Steckkarte (1) aus einem Steckkörper (2) wie z. B. einem Slot auf einem Motherboard eines Computers mit einem am Steckkörper (2) angeordneten Kulissenschieber (6),
**dadurch gekennzeichnet, daß**
der Kulissenschieber (6) einen um den Steckkörper (2) angeordneten Unterkörper (8) und einen Oberkörper (11) aufweist, wobei der Oberkörper (11) durch Betätigung des Kulissenschiebers (6) nach oben bewegt wird und geeignet ist, auf die Unterseite der Steckkarte (1) einzuwirken, so daß die Steckkarte (1) aus dem Steckkörper (2) bewegbar ist.

2. Hilfsvorrichtung nach Anspruch 1,
**dadurch gekennzeichnet, daß**
die Hilfsvorrichtung in einem Computer mit Slotfeld (5) angeordnet ist und der Kulissenschieber (6) ein Betätigungsmittel (7) aufweist, das durch das Slotfeld (5) hindurchgeführt ist und von außen bedienbar ist.

3. Hilfsvorrichtung nach Anspruch 2,
**dadurch gekennzeichnet, daß**
das Betätigungsmittel (7) durch Drücken oder Ziehen den Kulissenschieber (6) zum Auswurf der Karte veranlaßt.

4. Hilfsvorrichtung nach Anspruch 1,
**dadurch gekennzeichnet, daß**
der Kulissenschieber (6) über einen Hebel (16) an der Oberseite der Steckkarte bedienbar ist.

5. Hilfsvorrichtung nach Anspruch 4,
**dadurch gekennzeichnet, daß**
pro Steckkörper eine isolierende Trennwand (17) vorgesehen ist und der Hebel (16) um eine Achse (18) in der isolierenden Trennwand (17) schwenkbar ist.

6. Hilfsvorrichtung nach einem der Ansprüche 1 bis 5,
**dadurch gekennzeichnet, daß**
der um den Steckkörper (2) angeordnete Unterkörper (8) rahmenartig ausgeführt ist.

7. Hilfsvorrichtung nach einem der Ansprüche 1 bis 6,
**dadurch gekennzeichnet, daß**
der Kulissenschieber (6) eine verschiebbare Kulissenmimik (9) aufweist.

8. Hilfsvorrichtung nach Anspruch 7,
**dadurch gekennzeichnet, daß**
zwischen Oberkörper (11) und Kulissenmimik (9) Rollen vorgesehen sind, welche eine schiefe Ebene (10) an der Kulissenmimik (9) bei Betätigung des Kulissenschiebers (6) hinaufrollen und somit den Oberkörper (11) nach oben bewegen.

## Claims

1. Assisting device for removing a plug-in card (1) from a plug-in body (2), for example a slot on a motherboard of a computer, having a link slide (6) which is arranged on the plug-in body (2),
**characterized in that**
the link slide (6) has a lower body (8), which is arranged around the plug-in body (2), and an upper body (11), the upper body (11) being moved upwards by actuating the link slide (6) and being suitable for acting on the underside of the plug-in card (1) such that the plug-in card (1) can be moved out of the plug-in body (2).

2. Assisting device according to Claim 1,
**characterized in that**
the assisting device is arranged in a computer with a slot panel (5), and the link slide (6) has an actuating means (7) which is guided through the slot panel (5) and can be operated from the outside.

3. Assisting device according to Claim 2,
**characterized in that**
the actuating means (7) causes the link slide (6) to eject the card by means of pushing or pulling.

4. Assisting device according to Claim 1,
**characterized in that**
the link slide (6) can be operated using a lever (16) on the top side of the plug-in card.

5. Assisting device according to Claim 4,
**characterized in that**
an insulating separating wall (17) is provided for each plug-in body, and the lever (16) can be pivoted about an axis (18) in the insulating separating wall (17).

6. Assisting device according to one of Claims 1 to 5,
**characterized in that**
the lower body (8) which is arranged around the plug-in body (2) is in the form of a frame.

7. Assisting device according to one of Claims 1 to 6,
**characterized in that**
the link slide (6) has a displaceable link mimicking means (9).

8. Assisting device according to Claim 7,
**characterized in that**
rollers which roll up an inclined plane (10) on the link mimicking means (9) when the link slide (6) is actuated and thus move the upper body (11) upwards are provided between the upper body (11) and the link mimicking means (9).

## Revendications

1. Dispositif d'assistance pour enlever une carte enfichable (1) d'un corps d'enfichage (2) comme par exemple une fente d'une carte mère d'un ordinateur, comprenant un coulisseau (6) disposé sur le corps d'enfichage (2),
**caractérisé en ce que**
le coulisseau (6) présente un corps inférieur (8) disposé autour du corps d'enfichage (2) et un corps supérieur (11), le corps supérieur (11) étant déplacé vers le haut par l'actionnement du coulisseau (6) et étant approprié pour agir sur le côté inférieur de la carte enfichable (1), de sorte que la carte enfichable (1) puisse être déplacée hors du corps d'enfichage (2).

2. Dispositif d'assistance selon la revendication 1,
**caractérisé en ce que**
le dispositif d'assistance est disposé dans un ordinateur ayant un champ de fentes (5) et le coulisseau (6) présente un moyen d'actionnement (7) qui est guidé à travers le champ de fentes (5) et qui peut être commandé depuis l'extérieur.

3. Dispositif d'assistance selon la revendication 2,
**caractérisé en ce que**
le moyen d'actionnement (7) permet d'éjecter la carte par pression ou traction sur le coulisseau (6).

4. Dispositif d'assistance selon la revendication 1,
**caractérisé en ce que**
le coulisseau (6) peut être commandé par le biais d'un levier (16) sur le côté supérieur de la carte enfichable.

5. Dispositif d'assistance selon la revendication 4,
**caractérisé en ce que**
l'on prévoit une paroi de séparation isolante (17) pour chaque corps d'enfichage, et le levier (16) peut pivoter autour d'un axe (18) dans la paroi de séparation isolante (17).

6. Dispositif d'assistance selon l'une quelconque des revendications 1 à 5,
**caractérisé en ce que**
le corps inférieur (8) disposé autour du corps d'enfichage (2) est réalisé sous la forme d'un cadre.

7. Dispositif d'assistance selon l'une quelconque des revendications 1 à 6,
**caractérisé en ce que**
le coulisseau (6) présente un élément de type coulisse déplaçable (9).

8. Dispositif d'assistance selon la revendication 7,
**caractérisé en ce que**
l'on prévoit entre le corps supérieur (11) et l'élément de type coulisse (9) des galets qui roulent sur un plan incliné (10) sur l'élément de type coulisse (9) lors de l'actionnement du coulisseau (6) et qui déplacent ainsi vers le haut le corps supérieur (11).
